# EUROPÄISCHE PATENTSCHRIFT

(11) **EP 3 778 239 B1**
(45) Veröffentlichungstag und Bekanntmachung des Hinweises auf die Patenterteilung: **26.04.2023**
(21) Anmeldenummer: 20190410.9
(22) Anmeldetag: 11.08.2020
(51) Int. Cl.: B05B 5/025, B05B 5/053, B29C 48/00, B29C 48/02, B29C 48/05, B29C 48/154, B29C 48/345, B29C 48/92, B41J 2/005, H01L 31/0224

(54) **VERFAHREN UND VORRICHTUNG ZUM PARALLELEXTRUDIEREN VON DRUCKMEDIUM AUF EIN SUBSTRAT**
METHOD AND DEVICE FOR PARALLEL EXTRUDING OF PRINTING MEDIUM ONTO A SUBSTRATE
PROCÉDÉ ET DISPOSITIF D'EXTRUSION PARALLÈLE DE MATIÈRE D'IMPRESSION SUR UN SUBSTRAT

(30) Priorität: 16.08.2019 DE 102019122131
(43) Veröffentlichungstag der Anmeldung: 17.02.2021
(73) Patentinhaber: Fraunhofer-Gesellschaft zur Förderung der angewandten Forschung e.V., 80686 München (DE)
(72) Erfinder: TEPNER, Sebastian, 79110 Freiburg (DE); POSPISCHIL, Maximilian, 79110 Freiburg (DE); BREITENBÜCHER, Marian, 79110 Freiburg (DE); LACMAGO, Igor, 79110 Freiburg (DE); KUCHLER, Martin, 79110 Freiburg (DE); KLAWITTER, Markus, 79110 Freiburg (DE); KLEMENS, Marcel, 79117 Freiburg (DE); RIEBE, Tim, 88400 Biberach (DE)
(74) Vertreter: LBP Lemcke, Brommer & Partner Patentanwälte mbB

(56) Entgegenhaltungen:
- EP-A1- 2 837 459
- EP-A2- 0 363 033
- WO-A1-2014/077335
- CN-B- 103 456 835
- JP-A- 2017 098 460
- US-B1- 6 534 129

## Beschreibung

Die Erfindung betrifft eine Vorrichtung und ein Verfahren zum Parallelextrudieren von Druckmedium auf ein Substrat gemäß Oberbegriffe der Ansprüche 1 und 9.

Bei industriellen Druckvorgängen, insbesondere bei der Herstellung von Halbleiterstrukturen, wie beispielsweise photovoltaischen Solarzellen, ist es häufig wünschenswert, ein Druckmedium in einer Mehrzahl paralleler Bahnen auf ein Substrat aufzubringen. Solch ein Druckmedium kann eine Druckpaste sein, welche insbesondere einen Dotierstoff zur Dotierung eines oder mehrerer Bereiche der Halbleiterstruktur enthält, welche zur Ausbildung einer Maskierung für nachfolgende Prozessschritte dient und/oder welche Metallpartikel zum Ausbilden einer metallischen Kontaktstruktur enthält.

Aus DE 10 2013 223 250 A1 ist ein Druckkopf zum Aufbringen mehrerer paralleler Druckmedienlinien auf ein Substrat bekannt.

Häufig ist es wünschenswert, Linien mit möglichst geringer Breite aufzubringen, um beispielsweise Rekombinationsverluste an einer Metall-Halbleiterkontaktfläche zu verringern und/oder Abschattungsverluste durch eine metallische Kontaktierungsstruktur einer photovoltaischen Solarzelle zu verringern.

Das Aufbringen dünner, paralleler Linien aus Druckmedium auf ein Substrat erfordert, dass die Ausgabeöffnungen des Druckkopfes sich im geringen Abstand zu der Oberfläche des Substrats befinden, um gebogene Linien aufgrund schräg verlaufender Druckmediumstränge aus den Ausgabeöffnungen zu vermeiden. Es sind Anwendungen bekannt, bei welchen die Ausgabeöffnungen des Druckkopfes in einem Abstand von lediglich 50 µm relativ zu dem Substrat bewegt werden.

Ein solch geringer Abstand erfordert eine hohe Präzision der Bewegungsführung zwischen Druckkopf und Substrat. Darüber hinaus treten Probleme auf, wenn das Substrat Unebenheiten aufweist. Ein Nachführen des Druckkopfes zur Kompensation solcher Unebenheiten erfordert einen hohen Aufwand und ist wirtschaftlich nicht möglich. Darüber hinaus können Unebenheiten lediglich im Bereich einer oder einer Untergruppe der Ausgabeöffnungen auftreten, sodass eine Kompensation des Abstandes zu einem zu großen Abstand bei den verbleibenden Ausgabeöffnungen führen würde.

Aus CN 103456835 B ist eine Druckvorrichtung bekannt, mit der ein Substrat mit Silberpaste bedruckt wird. Die Silberpaste wird mittels einer Vielzahl an Düsen auf die Oberfläche des Substrats aufgetragen, welches auf einer flächigen Unterlage angeordnet ist. Die Düsen und die Unterlage sind mit einer Spannungsquelle verbunden und dienen als Elektrode und Gegenelektrode, um ein elektrisches Feld zu erzeugen.

Der vorliegenden Erfindung liegt die Aufgabe zugrunde, eine Vorrichtung und ein Verfahren zur Verfügung zu stellen, welches einen größeren Abstand zwischen Ausgabeöffnung des Druckkopfs und Substrat und dennoch eine hohe Präzision beim Aufbringen paralleler, geradliniger Linien aus Druckmedium ermöglicht.

Gelöst ist diese Aufgabe durch eine Vorrichtung gemäß Anspruch 1 sowie ein Verfahren gemäß Anspruch 9.

Vorteilhafte Ausgestaltungen finden sich in den abhängigen Unteransprüchen.

Die erfindungsgemäße Vorrichtung ist bevorzugt zur Durchführung des erfindungsgemäßen Verfahrens, insbesondere einer vorteilhaften Ausgestaltung hiervon, ausgebildet. Das erfindungsgemäße Verfahren ist bevorzugt zum Durchführen mittels der erfindungsgemäßen Vorrichtung, insbesondere einer bevorzugten Ausführungsform hiervon, ausgebildet.

Die erfindungsgemäße Vorrichtung zum Parallelextrudieren von Druckmedium auf ein Substrat, insbesondere zur Herstellung paralleler Leiterbahnen, weist einen Druckkopf mit einem Druckmediumeingang für das Druckmedium auf, welcher fluidleitend mit einer Mehrzahl von Ausgabeöffnungen des Druckkopfes verbunden ist, zur gleichzeitigen Ausgabe von Druckmedium aus den Ausgabeöffnungen in mehreren parallelen Druckmediumsträngen.

Die Mehrzahl paralleler Druckmediumstränge trifft bei Verwendung somit auf die Oberfläche des Substrats auf, bevorzugt senkrecht zur Oberfläche des Substrats. Durch eine Relativbewegung zwischen Druckkopf und Substrat werden auf dem Substrat mehrere parallele Linien aus Druckmedium aufgetragen.

Wesentlich ist, dass die Druckvorrichtung ein Elektrodenelement, ein Gegenelektrodenelement und eine Spannungsquelle aufweist, wobei die Spannungsquelle mit Elektrodenelement und Gegenelektrodenelement zusammenwirkend ausgebildet ist, um zwischen Elektrodenelement und Gegenelektrodenelement eine elektrische Potenzialdifferenz und ein damit verbundenes elektrisches Feld zu erzeugen, das das Elektrodenelement derart angeordnet und ausgebildet ist, um zu dem Druckmedium elektrische Ladung zu- oder abzuführen, sodass die Druckmediumstränge mit elektrischer Ladung gleicher Polarität aufladbar sind und dass die Vorrichtung derart ausgebildet ist, dass das Substrat zwischen Druckkopf und Gegenelektrodenelement anordenbar ist.

Die Vorrichtung ist in der Erkenntnis begründet, dass nicht geradlinige Bahnen von Druckmedium auf dem Substrat insbesondere dadurch entstehen, dass die Druckmediumstränge zwischen Ausgabeöffnungen des Druckkopfes und Substrat nicht parallel verlaufen. Ein Aufladen der Druckmediumstränge mit gleicher Polarität führt jedoch zu einer abstoßenden Kraft zwischen den Druckmediumsträngen, die gemäß den Untersuchungen der Anmelderin einen parallelen Verlauf der Druckmediumstränge erheblich begünstigt.

Die erfindungsgemäße Vorrichtung ist somit ausgebildet, aus den Ausgabeöffnungen des Druckkopfes eine Mehrzahl paralleler Druckmediumstränge auszugeben, die mit gleicher Polarität elektrisch aufgeladen sind, das heißt alle jeweils positiv oder alle jeweils negativ elektrisch aufgeladen sind.

Hierdurch kann der Abstand zwischen Ausgabeöffnungen des Druckkopfes und Oberfläche des Substrats während des Druckvorgangs erhöht werden und dennoch ist ein paralleler Verlauf der Druckmediumstränge gewährleistet, sodass parallele, geradlinige Linien von Druckmedium auf das Substrat aufgebracht werden.

Das erfindungsgemäße Verfahren dient zum Parallelextrudieren von Druckmedium auf ein Substrat, insbesondere zur Herstellung paralleler Leiterbahnen. Bei dem erfindungsgemäßen Verfahren werden mehrere parallele Druckmediumstränge aus Ausgabeöffnungen eines Druckkopfes auf ein Substrat ausgegeben und der Druckkopf und das Substrat werden relativ zueinander bewegt. Wesentlich ist, dass die Druckmediumstränge vor Aufbringen auf das Substrat elektrisch geladen werden, wobei alle Druckmediumstränge die gleiche Polarität der Ladung aufweisen.

Hierdurch ergeben sich die zuvor bei Beschreibung der erfindungsgemäßen Vorrichtung genannten Vorteile.

Ohne das Druckmedium vor Ausgabe jeweils eines Druckmediumstrangs aus einer Ausgabeöffnung mit elektrischer Ladung zu beaufschlagen, ist es vorteilhaft, dass das Druckmedium das Elektrodenelement durchdringt. Vorteilhafterweise weist das Elektrodenelement eine Mehrzahl von Leitungswegen für das Druckmedium auf. Hierdurch ist ein effektiver Ladungsaustausch zwischen Elektrodenelement und Druckmedium möglich. Insbesondere ist es vorteilhaft, dass das Elektrodenelement die Ausgabeöffnungen aufweist. In dieser vorteilhaften Ausbildung tritt das Druckmedium somit nach Durchdringen des Elektrodenelementes aus den Ausgabeöffnungen in Form mehrerer paralleler Druckmediumstränge aus. Hierdurch wird vermieden, dass durch einen Kontakt des Druckmediums mit Elementen des Druckkopfes nach Aufladen des Druckmediums Ladung von dem Druckmedium wieder abgegeben und insbesondere das Druckmedium wieder neutralisiert wird.

Das Elektrodenelement ist vorteilhafterweise an dem Druckkopf angeordnet. In einer weiter vorteilhaften Ausführungsform ist der Druckkopf als Elektrodenelement ausgebildet. In vielen Anwendungsfällen ist es vorteilhaft, den Druckkopf aus elektrisch leitendem Material, insbesondere aus Metall, auszubilden. Hierdurch kann in konstruktiv unaufwendiger Weise der Druckkopf mit der Spannungsquelle verbunden werden, sodass der Druckkopf ausschließlich Elektrodenelement dient. Aufgrund des großflächigen Kontaktes zwischen Druckmedium und Druckkopf ist ein effizienter Austausch von Ladungsträgern gewährleistet.

Das Ausbilden der parallelen Linien aus Druckmedium aus dem Substrat erfolgt bevorzugt in an sich bekannter Weise, insofern eine Relativbewegung zwischen Druckkopf und Substrat erfolgt. Hierbei liegt es im Rahmen der Erfindung, dass der Druckkopf über ein ruhendes Substrat bewegt wird, bevorzugt in einer geradlinigen Bewegung. Ebenso liegt es im Rahmen der Erfindung, dass das Substrat relativ zu dem Druckkopf bewegt wird, insbesondere bevorzugt mittels einer Fördervorrichtung wie beispielsweise einem Förderband.

Die Vorrichtung weist daher bevorzugt eine Transporteinheit auf, welche ausgebildet ist, das Substrat relativ zu Druckkopf, Elektrodenelement und Gegenelektrodenelement zu bewegen, insbesondere geradlinig zu bewegen. Hierdurch ergibt sich eine konstruktiv einfache Ausgestaltung, da lediglich das Substrat bewegt werden muss.

Ebenso liegt es im Rahmen der Erfindung, dass Druckkopf und Elektrodenelement relativ zu Substrat und Gegenelektrodenelement bewegt werden oder dass Druckkopf, Elektrodenelement und Gegenelektrodenelement relativ zu dem Substrat bewegt werden.

Vorteilhafterweise ist während der Relativbewegung zwischen Druckkopf und Substrat der Abstand zwischen Druckkopf und Substrat konstant. Wie zuvor beschrieben, ermöglicht das erfindungsgemäße Verfahren einen im Vergleich zu vorbekannten Verfahren größeren Abstand zwischen Druckkopf und Substrat, insbesondere beträgt der Abstand zwischen den Ausgabeöffnungen des Drucckopfes und dem Substrat bevorzugt zumindest 0,75 mm, weiter bevorzugt zumindest 1 mm, insbesondere zumindest 1,25 mm. Während des Aufbringens von Druckmedium auf das Substrat sind Druckkopf und Elektrodenelement auf einer Seite des Substrats, bevorzugt über dem Substrat, angeordnet und die Gegenelektrode ist auf der dem Druckkopf und dem Elektrodenelement gegenüberliegenden Seite des Substrats angeordnet, insbesondere bevorzugt unter dem Substrat angeordnet.

Die Anordnung des Druckkopfes über dem Substrat weist den Vorteil auf, dass die Bewegungsrichtung der Druckmediumstränge in Richtung Substrat durch die Schwerkraft unterstützt wird.

Untersuchungen der Anmeldering zeigen, dass bei Abständen zwischen Ausgabeöffnungen des Druckkopfes und der Oberfläche des Substrates bis zu 3 mm, die abstoßende Auslenkung der jeweiligen randständigen Druckstränge vernachlässigt werden kann. Bei größeren Abständen kann ein überstehendes Element am Druckkopf als Potenzialquelledienen, welche die Funktion weiterer theoretischer Druckmediumstränge zur parallelen Führung der Druckmediumstränge übernimmt.

In einer vorteilhaften Ausführungsform weist das Elektrodenelement daher zumindest ein, bevorzugt zwei Randelemente auf. Das Randelement ist neben einer randständigen Ausgabeöffnung angeordnet, um eine nach außen wirkende Kraft zu vermeiden oder zumindest zu verringern. Das Randelement weist hierzu eine Ladung der Polarität auf, welche der Polarität des randständigen Druckmediumstrangs entspricht. Bevorzugt ist an beiden Seiten der Mehrzahl von Ausgabeöffnungen jeweils zumindest ein, bevorzugt jeweils genau ein Randelement angeordnet, um eine jeweils nach außen wirkende Kraft auf die randständigen Druckmediumstränge zu vermeiden oder zumindest zu verringern.

Das Gegenelektrodenelement kann in verschiedenen Formen und Ausgestaltungen ausgebildet sein.

In einer vorteilhaften Ausführungsform ist das Gegenelektrodenelement als Flächenelektrode ausgebildet.

In einer weiter vorteilhaften Ausführungsform wird eine Flächenelektrode verwendet, welche eine Breite aufweist, die größer als die Breite des zu bearbeitenden Substrats ist. Die Breite entspricht hierbei der Erstreckung der Elektrode senkrecht zu der Bewegungsrichtung der Relativbewegung zwischen Druckkopf und Substrat und somit auch senkrecht zu den erzeugten parallelen Linien aus Druckmedium auf dem Substrat.

Die größere Breite des Elektrodenelementes gegenüber dem Substrat führt zu vorteilhaften Feldlinien, welche einen parallelen Verlauf der Druckmediumstränge begünstigen.

Insbesondere ist es vorteilhaft, die Flächenelektrode mit einer Länge, das heißt einer Ausdehnung, in Bewegungsrichtung der Relativbewegung zwischen Druckkopf und Substrat und somit auch in Richtung der parallel aufgetragenen Linien von Druckmedium auf dem Substrat auszubilden, welche zumindest der Länge des Substrats entspricht, bevorzugt größer als die Länge des Substrats ist. Bei dieser vorteilhaften Ausgestaltung ist es insbesondere vorteilhaft, dass der Druckkopf und das Elektrodenelement relativ zu dem Substrat und dem Gegenelektrodenelement bewegt werden. Hierdurch ist keine synchrone Bewegung zwischen Druckkopf und Elektrodenelement einerseits und Gegenelektrodenelement andererseits notwendig, sodass sich eine apparativ weniger aufwendige Ausgestaltung ergibt. Erfindungsgemäß weist das Gegenelektrodenelement eine Mehrzahl von Teilelektroden auf, wobei eine Mehrzahl der Ausgabeöffnungen des Druckkopfes jeweils eine Teilelektrode zugeordnet ist. Insbesondere ist es vorteilhaft, dass jeder Ausgabeöffnung zumindest eine, bevorzugt genau eine Teilelektrode zugeordnet ist.

Hierdurch ergibt sich der Vorteil, dass ausgehend von jedem Druckmediumstrang Feldlinien an zumindest einer, bevorzugt genau einer diesem Druckmediumstrang zugeordneten Teilelektrode enden.

Hierdurch ist zusätzlich eine Alinierung möglich, da die Position der Teilelektrode sich auf den Auftreffpunkt des Druckmediumstrangs auf dem Substrat auswirkt. Eine Anordnung der Teilelektroden in Abständen, welche den gewünschten Abständen der aufzubringenden parallelen Linien von Druckmedium auf dem Substrat entspricht, erhöht somit die Genauigkeit der erzeugten Struktur. So ist es beispielsweise vorteilhaft, bei gewünschten äquidistanten parallelen Drucklinien auf dem Substrat entsprechend die Teilelektroden des Gegenelektrodenelementes äquidistant zueinander anzuordnen.

Die Teilelektroden sind somit bevorzugt derart angeordnet, dass ein aus einer Ausgabeöffnung austretender Druckmediumstrang sich in Richtung der dieser Ausgabeöffnung zugeordneten Teilelektrode erstreckt.

In einer vorteilhaften Ausführungsform sind die Teilelektroden als Punktelektroden ausgebildet. Hierdurch ist ein exakt definierter Verlauf der Feldlinien zu der jeweiligen Punktelektrode gewährleistet.

Erfindungsgemäß sind die Teilelektroden als geradlinige Linienelektroden ausgebildet, insbesondere als parallel angeordnete Linienelektroden. Die Linienelektroden entsprechen somit dem gewünschten Verlauf und dem gewünschten Abstand der parallel auf dem Substrat aufzubringenden Linien aus Druckmedium.

Es ist es vorteilhaft, bei Ausbildung der Teilelektroden als Pumpelektroden Druckkopf, Elektrodenelement und Gegenelektrodenelement relativ zu dem Substrat zu bewegen. Bei Ausbildung der Teilelektroden als Linienelektroden ist es hingegen insbesondere vorteilhaft, Druckkopf und Elektrodenelement relativ zum Substrat und Gegenelektrodenelement zu bewegen.

Bei dem erfindungsgemäßen Verfahren erfolgt entsprechend der erfindungsgemäßen Vorrichtung in konstruktiv unaufwendiger Weise bevorzugt die Aufladung der Druckmediumstränge mittels eines Elektrodenelementes und während des Druckvorgangs ist auf der dem Druckkopf abgewandten Seite des Substrats ein Gegenelektrodenelement angeordnet.

Vorteilhafterweise wird zwischen Elektrodenelement und Gegenelektrodenelement eine Spannung im Bereich von 0,05 bis 3 kV, insbesondere 0,3 kV ausgebildet, insbesondere bevorzugt bei einem Abstand von 1.5 mm zwischen Ausgabeöffnungen des Druckkopfes und der Oberfläche des Substrates und der Verwendung von Ag- oder Al-Druckpasten.

Wie eingangs beschrieben, ermöglicht das erfindungsgemäße Verfahren und ebenso die erfindungsgemäße Vorrichtung eine hohe Genauigkeit beim Aufbringen der Mehrzahl von parallelen Linien aus Druckmedium auf das Substrat. Mittels des erfindungsgemäßen Verfahrens und der erfindungsgemäßen Vorrichtung kann somit in einer vorteilhaften Weiterbildung insbesondere ein mehrstufiges Druckverfahren ausgeführt werden, welches zumindest zwei Druckdurchgänge aufweist:
In dieser vorteilhaften Ausführungsform wird in einem ersten Druckdurchgang eine erste Struktur paralleler Linien aus dem vorgenannten Druckmedium als erstes Druckmedium aufgebracht. In einem zweiten Druckdurchgang wird eine zweite Struktur paralleler Linien aus einem zweiten, zu dem ersten bevorzugt unterschiedlichen Druckmedium auf die erste Struktur paralleler Linien aufgebracht.

Hierdurch ist es somit möglich, ein hohes Aspektverhältnis zu erzielen, da durch das Aufeinanderdrucken von zumindest zwei Linien aus Druckmedium eine größere Höhe ohne oder mit zumindest nur geringerer Vergrößerung der Breite der Linie ermöglicht wird.

Alternativ oder zusätzlich ermöglicht die bevorzugte Verwendung zweier unterschiedlicher Druckmedien, unterschiedliche Funktionen bei nachfolgenden Prozessierungsschritten auszubilden:
Bei einer Vielzahl von Anwendungen und insbesondere bei der Herstellung von lokalen Kontaktierungsstrukturen und/oder lokalen Dotierungen bei Halbleiterbauelementen, insbesondere bei photovoltaischen Solarzellen, ist häufig die Oberfläche des Substrats, auf welche die parallelen Linien aus Druckmedium aufgebracht werden, mit einer elektrisch isolierenden Schicht bedeckt. Im Falle von auf Silizium basierenden photovoltaischen Solarzellen weist das Substrat typischerweise eine Isolierungsschicht in Form einer Siliziumoxidschicht oder Siliziumnitridschicht auf. Es ist wünschenswert, dass das Druckmedium die Isolierungsschicht durchdringt, um in dem Halbleitersubstrat eine Dotierung zu erzeugen mittels eines im Druckmedium enthaltenen Dotierstoffes und/oder um einen elektrischen Kontakt mit Metallpartikeln des Druckmediums zu dem Halbleitersubstrat auszubilden.

Es ist daher bekannt, nach Aufbringen des Druckmediums einen Temperaturschritt durchzuführen, in dem zumindest das Druckmedium, bevorzugt das gesamte Substrat mit Druckmedium, erhitzt wird. Typische Druckmedien weisen Glasfritte auf, um ein Durchdringen einer elektrisch isolierenden Schicht in einem Temperaturschritt zu erzielen.

Die zuvor beschriebene zumindest zweistufige Ausgestaltung des Druckverfahrens ist vorteilhafterweise derart ausgebildet, dass das erste Druckmedium die elektrisch isolierende Schicht durchdringt, das zweite Druckmedium jedoch nicht.

Dies kann in einer vorteilhaften Ausgestaltung derart erzielt werden, dass das erste Druckmedium zum Durchdringen der elektrischen isolierenden Schicht ausgebildet ist, beispielsweise Glasfritte aufweist, dass zweite Druckmedium jedoch nicht zum Durchdringen der elektrisch isolierenden Schicht in einem nachfolgenden Temperaturschritt ausgebildet ist, insbesondere keine Glasfritte aufweist.

Ebenso kann in einer weiter vorteilhaften Ausführungsform zunächst das erste Druckmedium aufgebracht werden und mittels Temperatureinwirkung die Durchdringung der elektrisch isolierenden Schicht erzielt werden und nach diesem Schritt wird im zweiten Druckdurchgang das zweite Druckmedium auf die zuvor aufgebrachten Linien von erstem Druckmedium, welche die elektrisch isolierende Schicht bereits durchdrungen haben, aufgebracht. Auch hier bietet das erfindungsgemäße Verfahren und ebenso die erfindungsgemäße Vorrichtung erhebliche Vorteile, da die genaue Alinierung, das heißt, dass das Übereinanderaufbringen und das Vermeiden eines Nebeneinanderaufbringens der im ersten und zweiten Druckvorgang aufgebrachten Drucklinien durch die hohe Präzision des erfindungsgemäßen Verfahrens und der erfindungsgemäßen Vorrichtung ermöglicht werden.

Die Mehrzahl von Ausgabeöffnungen sind bevorzugt entlang einer geradlinigen Linie angeordnet.

Weitere vorteilhafte Merkmale und Ausführungsformen werden im Folgenden anhand von Ausführungsbeispielen und den Figuren erläutert. Dabei zeigt:
- Figur 1: zwei Ausführungsbeispiele einer erfindungsgemäßen Vorrichtung mit Flächenelektrode als Gegenelektrodenelement;
- Figur 2: zwei Ausführungsbeispiele mit einem Gegenelektrodenelement, welches Teilelektroden aufweist; und
- Figur 3: Verfahrensschritte zur Herstellung einer metallischen Kontaktierungsstruktur einer photovoltaischen Solarzelle.

Die Figuren zeigen schematische, nicht maßstabsgetreue Darstellungen. Gleiche Bezugszeichen in den Figuren bezeichnen gleiche oder gleichwirkende Elemente.

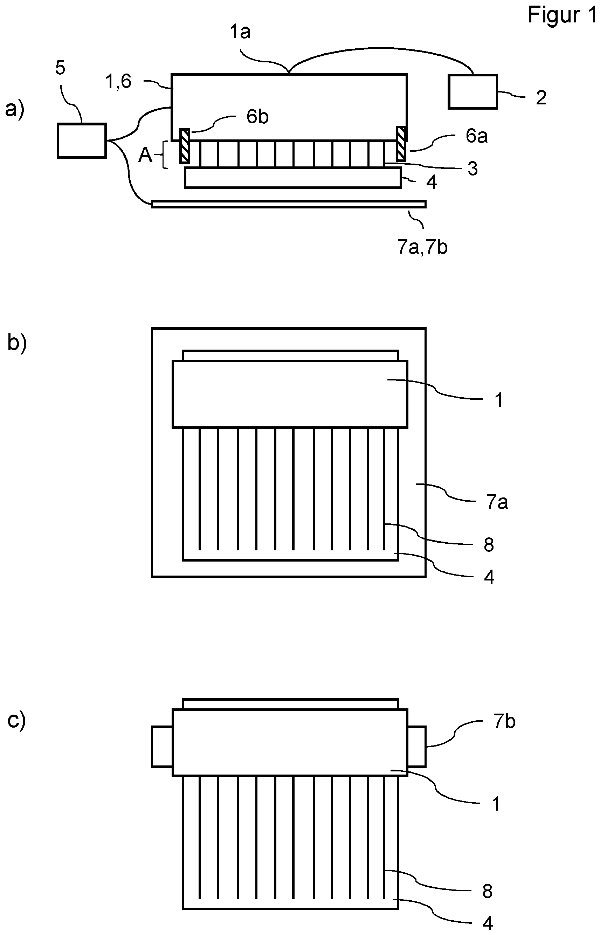

In Figur 1 ist in den Teilbildern b und c jeweils ein Ausführungsbeispiel einer erfindungsgemäßen Vorrichtung in Draufsicht von oben in Teildarstellung dargestellt. Die Seitenansicht der in Figur 1a und Figur 1c gezeigten Ausführungsbeispiele ist gleich und in Figur 1a dargestellt:
Beide Ausführungsbeispiele weisen einen Druckkopf 1 auf mit einem Druckmediumeingang 1a. Der Druckmediumeingang 1a ist über eine Leitung mit einem Druckmediumreservoir 2, welches eine Pumpe enthält, verbunden, sodass Druckmedium aus dem Druckmediumreservoir 2 über den Druckmediumeingang 1a in den Druckkopf 1 geführt werden kann.

An der in Figur 1a untenliegenden Seite des Druckkopfes 1 weist dieser eine Vielzahl von Ausgabeöffnungen für das Druckmedium auf, in der schematischen Darstellung der Figuren sind elf Ausgabeöffnungen gezeigt, aus denen Druckmediumstränge 3 austreten, wobei der Übersicht halber lediglich der rechte Druckmediumstrang mit Bezugszeichen 3 gekennzeichnet ist. Mittels des Drucckopfes 1 werden somit elf parallele Druckmediumstränge 3 auf ein unter dem Druckkopf 1 angeordnetes Substrat 4 geleitet, sodass die Druckmediumstränge 3 senkrecht von oben auf das Substrat 4 auftreffen. In realen Ausführungsformen werden eine größere Anzahl von Drucklinien parallele gedruckt, insbesondere im Bereich 100 bis 200 Drucklinien. Zur besseren Darstellbarkeit sind in den Figuren elf parallele Linien gezeigt.

Das Substrat 4 stellt eine Precursor bei der Herstellung einer photovoltaischen Solarzelle dar. Das Substrat 4 basiert auf einem Siliziumwafer, welcher bereits eine Basisdotierung und eine vorderseitige Emitterdotierung und eine auf der in Figur 1a obenliegenden Vorderseite des Substrats 4 aufgebrachte Isolierungsschicht aufweist, welche als Siliziumoxidschicht ausgebildet ist.

Bei den in Figur 1 dargestellten Ausführungsbeispielen wird der Druckkopf 1 relativ zu dem Substrat 4 bewegt, gemäß der Darstellung in Figur 1a senkrecht zur Zeichenebene. Auf diese Weise lassen sich somit elf parallele Linien von Druckmedium auf der Oberfläche des Substrates 4 ausbilden.

Die Druckvorrichtungen gemäß der in Figur 1 dargestellten Ausführungsbeispiele weisen weiterhin eine Spannungsquelle 5 auf. Der Druckkopf 1 ist aus Metall ausgebildet und stellt somit ein Elektrodenelement 6 dar.

Unter dem Substrat 4 ist ein Gegenelektrodenelement 7a bzw. 7b angeordnet, welches jeweils als Flächenelektrode ausgebildet ist.

Die Spannungsquelle 5 ist mit dem Elektrodenelement 6, das heißt mit dem Druckkopf 1, und dem Gegenelektrodenelement 7a, 7b verbunden, um zwischen diesen Elementen eine elektrische Potenzialdifferenz (Spannung) von bis zu 2 kV, vorliegend 1,5 kV zu erzeugen.

Der Druckkopf 1 als Elektrodenelement 6 ist wie zuvor beschrieben aus Metall und somit elektrisch leitend ausgebildet, sodass Elektronen von dem Druckmedium mittels der Spannungsquelle 5 abgeführt werden, sodass jeder der elf Druckmediumstränge 3 eine positive elektrische Ladung und somit eine Ladung gleicher Polarität aufweist. Zwischen den Druckmediumsträngen 3 besteht somit eine abstoßende Kraft, welche das Risiko eines Abweichens der Druckmediumstränge 3 von dem parallelen Verlauf, wie in Figur 1a dargestellt, verringert. Ein Druckmediumstrang in Position i mit der Ladung qᵢ erfährt die Kraftwirkung nach den Gesetzen der Elektrostatik in Abhängigkeit der umgebenen Ladungen. Ein Ungleichgewicht der totalen Ladungsmenge links bzw. rechts vom Druckmediumstrang i führt zu keiner Verzerrung der Parallelität, da die Kraftwirkung entsprechend mit der zweiten Potenz des Abstandes zur jeweiligen Ladung reduziert wird. Direkt benachbarte Druckmedienstränge üben demnach den dominierenden Anteil der Kraftwirkung aus und stellen die Parallelität der Druckmedienstränge zueinander sicher (Selbstalignierende Eigenschaft).

In den beiden in Figur 1 gezeigten Ausführungsbeispielen weist somit jeweils das Elektrodenelement 6, welches als Druckkopf 1 ausgebildet ist, die Mehrzahl von Ausgabeöffnungen für das Druckmedium auf.

In den Figuren 1b und c ist eine Draufsicht von oben auf das jeweilige Ausführungsbeispiel gezeigt.

In dem in Figur 1b gezeigten ersten Ausführungsbeispiel ist das Gegenelektrodenelement 7a als Flächenelektrode ausgebildet, welche eine größere Fläche als das Substrat 4 aufweist. In diesem Ausführungsbeispiel wird mittels einer nicht dargestellten Transporteinheit der Druckkopf 1 gemäß der Darstellung in Figur 1b von unten nach oben und somit wie zuvor ausgeführt in der Seitenansicht gemäß Figur 1a senkrecht zur Zeichenebene bewegt, sodass auf der Oberseite des Substrats 4 elf parallele Druckmediumlinien ausgebildet werden, von denen der Übersicht halber lediglich die rechte Druckmediumlinie mit dem Bezugszeichen 8 gekennzeichnet ist. Bei dem in Figur 1b gezeigten ersten Ausführungsbeispiel wird der Druckkopf 1 und somit auch das Elektrodenelement 6 relativ zum Substrat 4 und Gegenelektrodenelement 7a bewegt.

Bei dem in Figur 1c dargestellten zweiten Ausführungsbeispiel ist das Gegenelektrodenelement 7b ebenfalls als Flächenelektrode ausgebildet. Das Gegenelektrodenelement 7b weist zwar ebenfalls, wie auch das Gegenelektrodenelement 7a, eine größere Breite (waagrechte Erstreckung in den Figuren 1b und c) als das Substrat 4 auf. Im Gegensatz zu dem ersten Ausführungsbeispiel weist das Gegenelektrodenelement 7 des in Figur 1c dargestellten zweiten Ausführungsbeispiels jedoch keine größere Länge (senkrechte Erstreckung in den Figuren 1b und c) als das Substrat 4 auf.

Bei dem zweiten Ausführungsbeispiel werden sowohl Druckkopf 1 und somit auch Elektrodenelement 6 als auch das Gegenelektrodenelement 7b relativ zu dem Substrat 4 bewegt.

Wie eingangs beschrieben, ermöglichen insbesondere auch die in Figur 1 beschriebenen beiden Ausführungsbeispiele einen Abstand A von vorliegend 1,2 mm zwischen Druckkopf 1 und Substrat 4. Aufgrund der Ladung gleicher Polarität der Druckmediumstränge 3 ist dennoch das Aufbringen dünner paralleler Druckmediumlinien 8 (vorliegend mit einer Breite im Bereich von 15 µm bis 80µm, vorliegend 30 µm) möglich, die eine hohe Genauigkeit hinsichtlich der Geradlinigkeit und der Parallelität aufweisen.

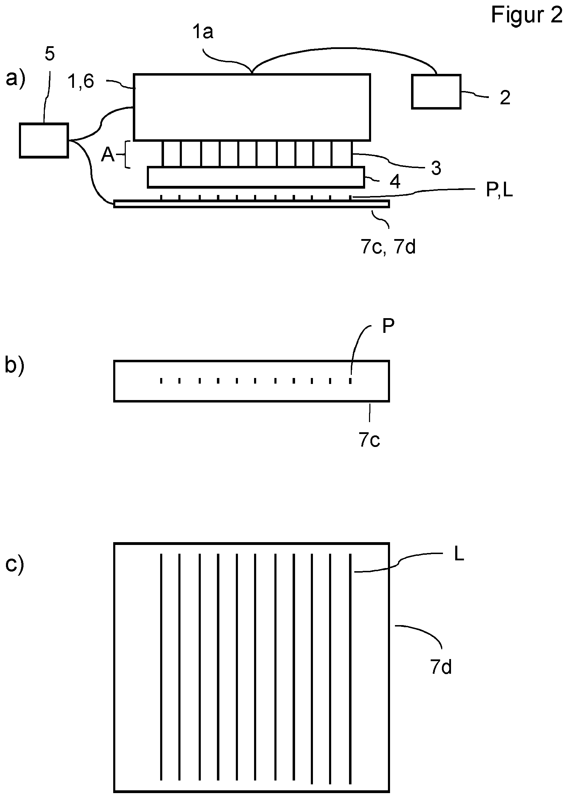

Eine noch höhere Genauigkeit und zusätzlich die Möglichkeit einer Alinierung, insbesondere bei Mehrfachdruckverfahren, bieten die in Figur 2 dargestellten Ausführungsbeispiele.

Auch hier ist analog zu Figur 1 in Figur 2a eine Seitenansicht dargestellt, die für das in Figur 2b und das in Figur 2c dargestellte Ausführungsbeispiel gleich ist.

Der Aufbau des dritten und vierten Ausführungsbeispiels gleicht wesentlich dem Aufbau des ersten und zweiten Ausführungsbeispiels, wobei die Gegenelektrodenelemente Unterschiede aufzeigen.

In Figur 2b ist daher lediglich das Gegenelektrodenelement 7c des dritten Ausführungsbeispiels und entsprechend in Figur 2c das Gegenelektrodenelement 7d des vierten Ausführungsbeispiels dargestellt.

Wie in Figur 2a ersichtlich, wird auch bei dem dritten und vierten Ausführungsbeispiel einer erfindungsgemäßen Vorrichtung der Druckkopf 1, welcher als Elektrodenelement 6 ausgebildet ist, über einen Druckmediumeingang 1a von dem Druckmediumreservoir 2 mit Druckmedium versorgt, um parallele Druckmediumstränge 3 aus Ausgabeöffnungen des Druckkopfes 1 auf das Substrat 4 auszugeben, welches in einem Abstand A zu dem Druckkopf 1 angeordnet ist. Mittels der Spannungsquelle 5 wird ein Potenzial zwischen Elektrodenelement 6 und Gegenelektrodenelement 7c, 7d erzeugt. Die Gegenelektrodenelemente 7b und 7c sind jedoch nicht als Flächenelektrodenelemente ausgebildet, sondern weisen jeweils Teilelektrodenelemente auf, wie in den Figuren 2b und 2c, welche eine Draufsicht auf die Gegenelektrodenelemente 7b und 7c zeigen, ersichtlich:
Das Gegenelektrodenelement 7b, 7c gemäß Figur 2b weist eine Mehrzahl von Punktelektroden auf, von denen aus Gründen der Übersichtlichkeit lediglich die Punktelektrode mit P gekennzeichnet ist. Die Anzahl entspricht der Anzahl der Ausgabeöffnungen des Druckkopfes 1. In der vorliegenden vereinfachten Darstellung somit elf Punktelektroden P. Die Punktelektroden P sind auf einer nicht leitenden Basisplatte des Gegenelektrodenelementes 7c angeordnet und lediglich über elektrische Kabel miteinander verbunden sowie mit einem seitlich angeordneten Anschluss, um die Punktelektroden P mit der Spannungsquelle 5 elektrisch leitend zu verbinden.

Das Gegenelektrodenelement 7c des vierten Ausführungsbeispiels ist ähnlich aufgebaut, weist jedoch statt Punktelektroden P Linienelektroden L auf. Die Linienelektroden L sind jeweils als gerade Linie ausgebildet, welche parallel zueinander angeordnet sind. Auch hier entspricht die Anzahl der Linienelektroden der Anzahl der Ausgabeöffnungen des Druckkopfes 1, vorliegend somit elf.

Der Abstand der Punktelektroden P sowie der Linienelektroden L entspricht ebenfalls dem Abstand der Ausgabeöffnungen des Druckkopfes 1 und somit auch dem gewünschten Abstand der aus dem Druckkopf 1 austretenden Druckmediumstränge 3 und der auf dem Substrat 4 auszubildenden parallelen Druckmediumlinien 8.

Die Feldlinien des auszubildenden elektrostatischen Feldes enden jeweils senkrecht auf der Gegenelektrode. Bei einer Ausführung der Gegenelektrode in voneinander getrennte Teilelektroden erfährt jeder Druckmediumstrang eine Kraftwirkung entlang der Feldlinien, welche es erschwert, dass der Druckmediumstrang eine Abweichung senkrecht zur Dispensierrichtung in Relation zur Position der Teilgegenelektrode erfahren kann.

Bei dem dritten Ausführungsbeispiel mit dem Gegenelektrodenelement 7c gemäß Figur 2b werden wie bei dem zweiten Ausführungsbeispiel Druckkopf 1 und somit Elektrodenelement 6 sowie Gegenelektrodenelement 7c relativ zu dem Substrat 4 bewegt. Bei dem vierten Ausführungsbeispiel mit Gegenelektrodenelement 7d gemäß Figur 2c erfolgt wie auch bei dem ersten Ausführungsbeispiel ein Bewegen von Druckkopf 1 und somit Elektrodenelement 6 relativ zum Substrat 4 und Gegenelektrodenelement 7d.

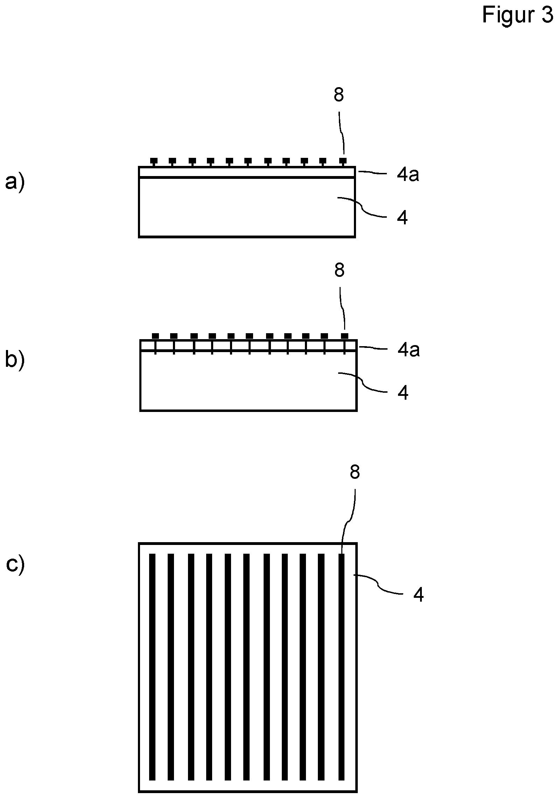

In Figur 3 sind verschiedene Verfahrensschritte dargestellt, um mittels eines zweistufigen Druckverfahrens eine metallische Kontaktierungsstruktur auf dem Substrat 4 auszubilden.

Das Substrat 4 ist in den Teilbildern a und b der Figur 3 jeweils in Seitenansicht und im Teilbild c der Figur 3 in Draufsicht von oben dargestellt.

Das Substrat 4 weist an der Oberfläche eine als Siliziumdioxidschicht ausgebildete elektrisch isolierende Isolierungsschicht 4a auf. Ebenso kann die Isolierungsschicht in einer Abwandlung des Ausführungsbeispiels anders ausgebildet sein, beispielsweise als Siliziumnitridschicht. Mittels der Vorrichtung gemäß des dritten Ausführungsbeispiel oder alternativ gemäß dem vierten Ausführungsbeispiel wurde zunächst in einem ersten Druckdurchgang ein erstes Druckmedium in dünnen Linien mit einer Breite im Bereich von 15 µm bis 80µm, vorliegend 40 µm auf die Isolierungsschicht 4a des Substrats 4 gedruckt. Anschließend wurde in einem zweiten Druckdurchgang ein zweites, zu dem ersten verschiedenes Druckmedium ebenfalls in Druckmediumlinien auf die Druckmediumlinien des ersten Durchgangs und somit auf das erste Druckmedium aufgebracht. Das erste Druckmedium weist verstärkt ätzende Glasfritte auf, das zweite Druckmedium hingegen nicht. Beide Druckmedien weisen hingegen Metallpartikel auf.

In einem für beide Druckmedien gemeinsam wirkenden Temperaturschritt wird das Substrat 4 erhitzt (auf etwa 700°C bis 850° C, vorliegend auf etwa 780°) für eine Zeitdauer im Bereich 20 Sekunden bis 40 Sekunden, vorliegend 30 Sekunden, sodass die Druckmediumlinien des ersten Druckmediums die Isolierungsschicht 4a durchdringen und einen elektrisch leitenden Kontakt mit dem Substrat 4 ausbilden. Die Druckmediumlinien des zweiten Druckmediums durchdringen die Isolierungsschicht 4a hingegen nicht.

Die Druckmediumlinien des ersten Druckmediums wurden bei dem vorliegenden Ausführungsbeispiel mit einer geringeren Breite (im Bereich 15 µm bis 70 µm, vorliegend 20 µm) gegenüber der Breite der Druckmediumlinien des zweiten Druckmediums (mit einer Breite im Bereich 20 µm bis 80 µm, vorliegend mit einer Breite von 60 µm) aufgebracht, sodass die auf der Isolierungsschicht 4a verbleibenden Druckmediumlinien des zweiten Druckmediums eine ausreichende Breite aufweisen, um einen geringen Querleitungswiderstand zu gewährleisten, wohingegen die dünneren Druckmediumlinien aus Druckmedium 1 als wesentliche Funktion die elektrisch leitende Verbindung zwischen den Druckmediumlinien des zweiten Druckmediums und dem Substrat 4 erfüllen.

Hierdurch ist einerseits eine ausreichende Querleitfähigkeit auf der Oberfläche der Isolierungsschicht 4a durch die Druckmediumlinien des zweiten Druckmediums gewährleistet und andererseits wird die Rekombination am Metall/Halbleiterkontakt durch die geringere Breite der Druckmediumlinien des ersten Druckmediums verringert. Ebenso liegt es im Rahmen der Erfindung, andere Breitenverhältnisse zu wählen, insbesondere beide Druckmediumlinien mit gleicher Breite aufzubringen.

In Figur 1 ist weiterhin eine Weiterbildung des vorbeschriebenen Ausführungsbeispiels gezeigt: In dieser Weiterbildung weist das Elektrodenelement 6 zwei schraffiert dargestellte Randelemente 6a und 6b auf. Die Randelemente 6a und 6b sind ebenfalls metallisch ausgebildet und mit dem als Druckkopf 1 ausgebildeten Elektrodenelement 6 leitend verbunden, so dass die Randelemente 6a, 6b die gleiche Potentialdifferenz zu der Gegenelektrode 7a wie auch der das Elektrodenelement 1 aufweisen. Hierdurch wird eine etwaige nach außen (d.h. in Figur 1 nach links bei dem linken randständigen Druckmediumstrang 3 und nach rechts bei dem rechten randständigen Druckmediumstrang 3) wirkende Kraft kompensiert oder zumindest verringert.

### Bezugszeichen

- A: Abstand
- 1: Druckkopf
- 1a: Druckmediumeingang
- 2: Druckmediumreservoir
- 3: Druckmediumstrang
- 4: Substrat
- 4a: Isolierungsschicht
- 5: Spannungsquelle
- 6: Elektrodenelement
- 6a, 6b: Randelement
- 7a, 7b, 7c, 7d: Gegenelektrodenelement
- P: Punktelektroden
- L: Linienelektroden
- 8: Druckmediumlinie

## Patentansprüche

1. Vorrichtung zum Parallelextrudieren von Druckmedium auf ein Substrat (4), insbesondere zur Herstellung paralleler Leiterbahnen,
mit einem Druckkopf (1) mit einen Druckmediumeingang (1a) für das Druckmedium, welcher fluidleitend mit einer Mehrzahl von Ausgabeöffnungen des Druckkopfes verbunden ist, zur gleichzeitigen Ausgabe von Druckmedium aus den Ausgabeöffnungen in mehreren parallelen Druckmediumsträngen, wobei die Druckvorrichtung ein Elektrodenelement (6), ein Gegenelektrodenelement (7a, 7b, 7c, 7d) und eine Spannungsquelle aufweist, wobei die Spannungsquelle mit Elektrodenelement (6) und Gegenelektrodenelement (7a, 7b, 7c, 7d) zusammenwirkend ausgebildet ist, um zwischen Elektrodenelement (6) und Gegenelektrodenelement (7a, 7b, 7c, 7d) eine elektrische Potentialdifferenz und damit verbundenes elektrostatisches Feld zu erzeugen,
wobei das Elektrodenelement (6) derart angeordnet und ausgebildet ist, um zu dem Druckmedium elektrische Ladung zu- oder abzuführen, so dass die Druckmediumstränge mit elektrischer Ladung gleicher Polarität aufladbar sind und
wobei die Vorrichtung derart ausgebildet ist, dass das Substrat (4) zwischen Druckkopf (1) und Gegenelektrodenelement (7a, 7b, 7c, 7d) anordenbar ist, **dadurch gekennzeichnet, dass**
das Gegenelektrodenelement (7a, 7b, 7c, 7d) eine Mehrzahl von Teilelektroden aufweist, wobei einer Mehrzahl der Ausgabeöffnungen des Druckkopfes jeweils eine Teilelektrode zugeordnet ist und die Teilelektroden als geradlinige Linienelektroden (L) ausgebildet sind.

2. Vorrichtung nach Anspruch 1,
**dadurch gekennzeichnet,**
**dass** das Elektrodenelement (6) eine Mehrzahl von Leitungswegen für das Druckmedium aufweist, insbesondere, dass das Elektrodenelement (6) die Mehrzahl von Ausgabeöffnungen aufweist.

3. Vorrichtung nach einem der vorangegangenen Ansprüche,
**dadurch gekennzeichnet,**
**dass** das Elektrodenelement (6) an dem Druckkopf (1) angeordnet ist, insbesondere, dass der Druckkopf (1) als Elektrodenelement (6) ausgebildet ist.

4. Vorrichtung nach einem der vorangegangenen Ansprüche,
**dadurch gekennzeichnet,**
**dass** das Gegenelektrodenelement (7a, 7b, 7c, 7d) als Flächenelektrode ausgebildet ist und die Vorrichtung eine Transporteinheit aufweist, welche ausgebildet ist, den Druckkopf (1) und das Elektrodenelement relativ zu dem Gegenelektrodenelement (7a, 7b, 7c, 7d) zu bewegen, insbesondere geradlinig zu bewegen, bevorzugt in einem konstanten Abstand (A) zu dem Gegenelektrodenelement (7a, 7b, 7c, 7d) zu bewegen.

5. Vorrichtung nach einem der vorangegangenen Ansprüche,
**dadurch gekennzeichnet,**
**dass** die Vorrichtung eine Transporteinheit aufweist, welche ausgebildet ist, das Substrat (4) relativ zu Druckkopf (1), Elektrodenelement (6) und Gegenelektrodenelement (7a, 7b, 7c, 7d) zu bewegen, insbesondere geradlinig zu bewegen, wobei bevorzugt der Abstand (A) zwischen Substrat (4) und Druckkopf (1) konstant ist.

6. Vorrichtung nach einem der vorangegangenen Ansprüche,
**dadurch gekennzeichnet,**
**dass** jeder Ausgabeöffnung zumindest eine, bevorzugt genau eine Teilelektrode zugeordnet ist.

7. Vorrichtung nach Anspruch 6,
**dadurch gekennzeichnet,**
**dass** die Teilelektroden derart angeordnet sind, dass ein aus einer Ausgabeöffnung austretender Druckmediumstrang (3) sich in Richtung der dieser Ausgabeöffnung zugeordneten Teilelektrode erstreckt.

8. Vorrichtung nach einem der vorangegangenen,
**dadurch gekennzeichnet,**
**dass** die Teilelektroden als parallel angeordnete Linienelektroden (L) ausgebildet sind.

9. Verfahren zum Parallelextrudieren von Druckmedium auf ein Substrat (4), insbesondere zur Herstellung paralleler Leiterbahnen,
wobei mehrere parallele Druckmediumstränge aus Ausgabeöffnungen eines Druckkopfes auf ein Substrat (4) ausgegeben werden und Druckkopf (1) und Substrat (4) relativ zueinander bewegt werden,
wobei die Druckmediumstränge vor Aufbringen auf das Substrat (4) elektrisch geladen werden, wobei alle Druckmediumstränge die gleiche Polarität der Ladung aufweisen,
**dadurch gekennzeichnet,**
**dass** die Aufladung der Druckmediumstränge mittels eines Elektrodenelement erfolgt und während des Druckvorgangs auf der dem Druckkopf (1) abgewandten Seite des Substrats ein Gegenelektrodenelement (7a, 7b, 7c, 7d) angeordnet ist, wobei zwischen Elektrodenelement (6) und Gegenelektrodenelement (7a, 7b, 7c, 7d) eine elektrische Potentialdifferenz und damit verbundenes elektrostatisches Feld ausgebildet ist, insbesondere im Bereich 0,05 kV bis 3 kV, und das Gegenelektrodenelement (7a, 7b, 7c, 7d) eine Mehrzahl von Teilelektroden aufweist, wobei einer Mehrzahl der Ausgabeöffnungen des Druckkopfes jeweils eine Teilelektrode zugeordnet ist und die Teilelektroden als geradlinige Linienelektroden (L) ausgebildet sind.

10. Verfahren nach Anspruch 9,
**dadurch gekennzeichnet,**
**dass** während des Druckvorgangs der Abstand (A) zwischen Druckkopf (1) und Substrat (4) größer 0,75 mm, insbesondere größer 1 mm, bevorzugt größer 1,25 mm ist.

11. Verfahren nach einem der Ansprüche 9 bis 10,
**dadurch gekennzeichnet,**
**dass** ein zweistufiger Druckvorgang durchgeführt wird,
wobei in einem ersten Druckdurchgang eine erste Struktur paralleler Linien aus dem Druckmedium als erstes Druckmedium aufgebracht wird und in einem zweiten Druckdurchgang ein zweite Struktur paralleler Linien aus einem zweiten, zu dem ersten unterschiedlichen Druckmedium auf die erste Struktur paralleler Linien aufgebracht wird.

12. Verfahren nach Anspruch 11,
**dadurch gekennzeichnet,**
**dass** Substrat (4) an der dem Druckkopf (1) zugewandten Seite eine elektrisch isolierende Isolierungsschicht (4a), aufweist,
**dass** das erste Druckmedium eine die Isolierungsschicht (4a) bei Temperaturwirkung durchdringende Substanz, bevorzugt Glasfritte, enthält und mittels Temperatureinwirkung ein Durchdringen der Isolierungsschicht (4a) durch das erste Druckmedium erzielt wird.

## Claims

1. Apparatus for parallel extruding printing medium onto a substrate (4), in particular for producing parallel conductive tracks, including a printing head (1) with a printing medium inlet (1a) for the printing medium, which is fluid conductively connected to a plurality of discharge openings in the printing head, for the simultaneous discharge of printing medium from the discharge openings in a plurality of parallel printing medium strands, wherein the printing apparatus includes an electrode element (6), a counter electrode element (7a, 7b, 7c, 7d) and a voltage source, wherein the voltage source is constructed to cooperate with electrode element (6) and counter electrode element (7a, 7b, 7c, 7d) in order to produce an electrical potential differential and an electrostatic field connected therewith between electrode element (6) and counter electrode element (7a, 7b, 7c, 7d), wherein the electrode element (6) is so arranged and constructed in order to supply electrical charge to the printing medium or to discharge it, so that the printing medium strands may be charged with an electrical charge of the same polarity and wherein the apparatus is so constructed that the substrate (4) may be arranged between the printing head (1) and the counter electrode element (7a, 7b, 7c, 7d), **characterised in that** the counter electrode element (7a, 7b, 7c, 7d) includes a plurality of component electrodes, wherein a plurality of the discharge openings in the printing head is associated with a respective component electrode and the component electrodes are constructed as straight, linear electrodes (L).

2. Apparatus as claimed in Claim 1, **characterised in that** the electrode element (6) includes a plurality of conduit paths for the printing medium, in particular that the electrode element (6) includes the plurality of discharge openings.

3. Apparatus as claimed in one of the preceding claims, **characterised in that** the electrode element (6) is arranged on the printing head (1), in particular that the printing head (1) is constructed as the electrode element (6).

4. Apparatus as claimed in one of the preceding claims, **characterised in that** the counter electrode element (7a, 7b, 7c, 7d) is constructed as a plate electrode and the apparatus includes a transport unit, which is constructed to move the printing head (1) and the electrode element relative to the counter electrode element (7a, 7b, 7c, 7d), in particular to move it in a straight line, preferably to move it at a constant distance (A) from the counter electrode element (7a, 7b, 7c, 7d).

5. Apparatus as claimed in one of the preceding claims, **characterised in that** the apparatus includes a transport unit, which is constructed to move the substrate (4) relative to the printing head (1), electrode element (6) and counter electrode element (7a, 7b, 7c, 7d), particularly to move it in a straight line, wherein the distance (A) between the substrate (4) and printing head (1) is preferably constant.

6. Apparatus as claimed in one of the preceding claims, **characterised in that** at least one, preferably precisely one, component electrode is associated with each discharge opening.

7. Apparatus as claimed in Claim 6, **characterised in that** the component electrodes are so arranged that a printing medium strand (3) exiting from a discharge opening extends in the direction of the component electrode associated with this discharge opening.

8. Apparatus as claimed in one of the preceding claims, **characterised in that** the component electrodes are constructed as parallel arranged linear electrodes (L).

9. A method of parallel extruding printing medium onto a substrate (4), particularly for producing parallel conductive tracks, wherein a plurality of parallel printing medium strands are discharged from discharge openings in a printing head onto a substrate (4) and printing head (1) and substrate (4) are moved relative to one another, wherein before their application to the substrate (4) the printing medium strands are electrically charged, wherein all the printing medium strands have the same polarity of charge, **characterised in that** the charging of the printing medium strands is effected by means of an electrode element and during the printing process a counter electrode element (7a, 7b, 7c, 7d) is arranged on the side of the substrate remote from the printing head (1), wherein an electrical potential difference and an electrostatic field associated therewith is formed between electrode element (6) and counter electrode element (7a, 7b, 7c, 7d), particularly in the range of 0.05 kV to 3 kV, and the counter electrode element (7a, 7b, 7c, 7d) includes a plurality of component electrodes, wherein a respective component electrode is associated with a plurality of the discharge openings in the printing head and the component electrodes are constructed as straight, linear electrodes (L).

10. A method as claimed in Claim 9, **characterised in that** during the printing process, the distance (A) between printing head (1) and substrate (4) is greater than 0.75 mm, in particular greater than 1 mm, preferably greater than 1.25 mm.

11. A method as claimed in one of Claims 9 to 10, **characterised in that** a two-stage printing process is conducted, wherein, in a first printing pass, a first structure of parallel lines of the printing medium, constituting a first printing medium, is applied and, in a second printing pass, a second structure of parallel lines of a second printing medium, different to the first, is applied to the first structure of parallel lines.

12. A method as claimed in Claim 11, **characterised in that** the substrate (4) has an electrically insulating insulation layer (4a) on the side remote from the printing head (1), that the first printing medium contains a substance, preferably glass frit, which penetrates the insulation layer (4a) under the effect of temperature and penetration of the insulation layer (4a) by the first printing medium is achieved by means of the action of temperature.

## Revendications

1. Dispositif d'extrusion parallèle de matière d'impression sur un substrat (4), en particulier pour la fabrication de pistes conductrices parallèles,
avec une tête d'impression (1) avec une entrée de matière d'impression (1a) pour la matière d'impression, qui est en relation fluidique avec une multiplicité d'ouvertures de distribution de la tête d'impression, pour la distribution simultanée de matière d'impression à partir des ouvertures de distribution en plusieurs lignes de matière d'impression parallèles,
dans lequel le dispositif d'impression comporte un élément à électrode (6), un élément à contre-électrode (7a, 7b, 7c, 7d) et une source de tension, dans lequel la source de tension est formée pour coopérer avec l'élément à électrode (6) et l'élément à contre-électrode (7a, 7b, 7c, 7d) pour produire entre l'élément à électrode (6) et l'élément à contre-électrode (7a, 7b, 7c, 7d) une différence de potentiel électrique et un champ électrostatique lié à celle-ci,
dans lequel l'élément à électrode (6) est disposé et formé pour alimenter la matière d'impression en charge électrique ou évacuer celle-ci de la matière d'impression, de sorte que les lignes de matière d'impression puissent être chargées avec une charge électrique de même polarité et
dans lequel le dispositif est formé de telle sorte que le substrat (4) puisse être disposé entre la tête d'impression (1) et l'élément à contre-électrode (7a, 7b, 7c, 7d),
**caractérisé en ce que** l'élément à contre-électrode (7a, 7b, 7c, 7d) comporte une multiplicité d'électrodes partielles, dans lequel une électrode partielle est associée à chacune d'une multiplicité d'ouvertures de distribution de la tête d'impression et les électrodes sont formées comme des électrodes linéaires (L) rectilignes.

2. Dispositif selon la revendication 1,
**caractérisé**
**en ce que** l'élément à électrode (6) comporte une multiplicité de voies de conduction pour la matière d'impression, en particulier **en ce que** l'élément à électrode (6) comporte la multiplicité d'ouvertures de distribution.

3. Dispositif selon l'une des revendications précédentes,
**caractérisé**
**en ce que** l'élément à électrode (6) est disposé sur la tête d'impression (1), en particulier **en ce que** la tête d'impression (1) est formée comme élément à électrode (6).

4. Dispositif selon l'une des revendications précédentes,
**caractérisé**
**en ce que** l'élément à contre-électrode (7a, 7b, 7c, 7d) est formé comme une électrode plane et le dispositif comporte une unité de transport qui est formée pour déplacer la tête d'impression (1) et l'élément à électrode par rapport à l'élément à contre-électrode (7a, 7b, 7c, 7d), en particulier en ligne droite, de préférence avec un écartement (A) constant par rapport à l'élément à contre-électrode (7a, 7b, 7c, 7d).

5. Dispositif selon l'une des revendications précédentes,
**caractérisé**
**en ce que** le dispositif comporte une unité de transport qui est formée pour déplacer le substrat (4) par rapport à la tête d'impression (1), à l'élément à électrode (6) et à l'élément à contre-électrode (7a, 7b, 7c, 7d), en particulier en ligne droite, l'écartement (A) entre le substrat (4) et la tête d'impression (1) étant de préférence constant.

6. Dispositif selon l'une des revendications précédentes,
**caractérisé**
**en ce qu'**à chaque ouverture de distribution est associée au moins une, de préférence exactement une électrode partielle.

7. Dispositif selon la revendication 6,
**caractérisé**
**en ce que** les électrodes partielles sont disposées de telle sorte qu'une ligne de matière d'impression (3) sortant d'une ouverture de distribution s'étende dans la direction de cette électrode partielle associée à cette ouverture de distribution.

8. Dispositif selon l'une des revendications précédentes,
**caractérisé**
**en ce que** les électrodes partielles sont formées comme des électrodes linéaires (L) disposées parallèlement.

9. Procédé d'extrusion parallèle de matière d'impression sur un substrat (4), en particulier pour la fabrication de pistes conductrices parallèles,
dans lequel plusieurs lignes de matière d'impression parallèles sont distribuées sur un substrat (4) à partir d'ouvertures de distribution d'une tête d'impression et la tête d'impression (1) et le substrat (4) sont déplacés l'une par rapport à l'autre,
dans lequel les lignes de matière d'impression sont chargées électriquement avant leur application sur le substrat (4), toutes les lignes de matière d'impression présentant la même polarité de la charge,
**caractérisé en ce que** le chargement des lignes de matière d'impression se fait à l'aide d'un élément à électrode, et pendant l'opération d'impression un élément à contre-électrode (7a, 7b, 7c, 7d) est disposé sur le côté du substrat opposé à la tête d'impression (1), dans lequel entre l'élément à électrode (6) et l'élément à contre-électrode (7a, 7b, 7c, 7d) une différence de potentielle électrique est produite, et un champ électrostatique lié à celle-ci, en particulier dans la plage de 0,05 kV à 3 kV, et l'élément à contre-électrode (7a, 7b, 7c, 7d) comporte une multiplicité d'électrodes partielles, une électrode partielle étant associée à chacune d'une multiplicité d'ouvertures de distribution de la tête d'impression et les électrodes partielles étant formées comme des électrodes linéaires (L) rectilignes.

10. Procédé selon la revendication 9,
**caractérisé**
**en ce que** pendant l'opération d'impression, l'écartement (A) entre la tête d'impression (1) et le substrat (4) est supérieur à 0,75 mm, en particulier supérieur à 1 mm, de préférence supérieur à 1,25 mm.

11. Procédé selon l'une des revendications 9 à 10,
**caractérisé**
**en ce qu'**une opération d'impression en deux étapes est exécutée,
dans lequel dans un premier passage d'impression, une première structure de lignes parallèles composée de la matière d'impression est appliquée comme première matière d'impression, et dans un deuxième passage d'impression, une deuxième structure de lignes parallèles composée d'une deuxième matière d'impression, différente de la première matière d'impression, est appliquée sur la première structure de lignes parallèles.

12. Procédé selon la revendication 11,
**caractérisé**
**en ce que** le substrat (4) comporte sur le côté tourné vers la tête d'impression (1) une couche d'isolation (4a) isolante électriquement,
**en ce que** la première matière d'impression contient une substance pénétrant à travers la couche d'isolation (4a) en présence d'un effet thermique, de préférence de la fritte de verre, et à l'aide de l'effet thermique une pénétration de la couche d'isolation (4a) par la première matière d'impression est obtenue.
